# EUROPEAN PATENT APPLICATION

(11) **EP 4 525 565 A1**
(43) Date of publication of application: **19.03.2025**
(21) Application number: 23827445.0
(22) Date of filing: 15.06.2023
(51) Int. Cl.: H05K 5/00, H05K 5/04, C25D 11/24, C25D 11/16, C09D 11/32, C25D 11/02, H04M 1/02

(54) **DEEP-COLORED HOUSING AND ELECTRONIC DEVICE COMPRISING SAME**

(30) Priority: 20.06.2022 KR 20220074971; 15.09.2022 KR 20220116030
(71) Applicant: Samsung Electronics Co., Ltd., Suwon-si, Gyeonggi-do 16677 (KR)
(72) Inventor: PARK, Hyesun, Suwon-si, Gyeonggi-do 16677 (KR); KIM, Goeun, Suwon-si, Gyeonggi-do 16677 (KR); KIM, Inkyu, Suwon-si, Gyeonggi-do 16677 (KR); KIM, Hyunsoo, Suwon-si, Gyeonggi-do 16677 (KR); LEE, Heesung, Suwon-si, Gyeonggi-do 16677 (KR); HEO, Sungyoung, Suwon-si, Gyeonggi-do 16677 (KR); JUNG, Youngsoo, Suwon-si, Gyeonggi-do 16677 (KR); CHOI, Hyunsuk, Suwon-si, Gyeonggi-do 16677 (KR)
(74) Representative: HGF
(86) International application number: PCT/KR2023/008269
(87) International publication number: WO 2023/249326

(57) **Abstract**

In an electronic device comprising a glossy housing, according to one embodiment of the present disclosure, the housing comprises a metal substrate, and an anodized layer overlapping the metal substrate, wherein the anodized layer can include: pore walls including a plurality of pores; and coloring dye particles including an organic dye and a conductivity enhancer, which are injected into the plurality of pores.

## Description

### [Technical Field]

An embodiments of the disclosure relates to a deep-colored housing and an electronic device including the same.

### [Background Art]

With the development of information and communication technology and semiconductor technology, the distribution and use of various mobile devices is rapidly increasing. Recent mobile devices provide ordinary users with an environment in which they may be carried while performing communication. Further, mobile devices may output stored information as voices or images. As mobile devices are highly integrated, and high-speed, high-volume wireless communication becomes commonplace, a mobile device, such as a mobile communication terminal, is recently being equipped with various functions. For example, a mobile device comes with the integrated functionality, including an entertainment function, such as playing video games, a multimedia function, such as replaying music/videos, a communication and security function for mobile banking, and/or a scheduling and e-wallet function. These mobile devices have been downsized to be conveniently carried by users. As the carrying and use of compact and slim mobile devices, e.g., smartphones, become commonplace, users demand diversified, high-class exterior design for mobile devices.

Users' demand for diversified, high-class exterior design for mobile devices lead to methods for implementing various colors or shapes. In general, metallic colors, such as silver and gold, have been preferred, but recently, there has been a growing preference for vivid colors, such as deep black, in terms of design.

Surface treatment methods for aluminum materials include anodizing, chemical conversion coating, electroplating, and/or vacuum coating. Anodizing is widely used for surface treatment of aluminum alloy materials with its capability of implementing various colors using dyes and the advantage of being able to obtain various colors by mixing various dyes or under coloring conditions. However, there are certain restrictions to implement deep colors, as follow. For example, when coloring is performed at a higher concentration of dye, if the concentration of the dye is 10g/L or more, quality deterioration may occur due to a difficulty in dissolving the dye and disturbance of coloring by the undissolved dye particles. For example, when the coloring time increases, the processing time also increases, resulting in a cost rise. These restrictions may render it difficult to implement a deep color of brightness (L*) 24 or less in conventional mobile devices.

The above-described information may be provided as background for the purpose of helping understanding of the disclosure. No claim or determination is made as to whether any of the foregoing is applicable as background art in relation to the disclosure.

### [Detailed Description of the Invention]

### [Technical Solution]

In an electronic device including a glossy housing according to an embodiment of the disclosure, the housing may include a metal substrate and an anodized layer formed by overlapping the metal substrate. The anodized layer may include a pore wall including a plurality of pores and a coloring dye particle including a conductivity enhancer and an organic dye injected to the plurality of pores.

A method for manufacturing a glossy housing of an electronic device, according to an embodiment of the disclosure, may comprise a glossing operation for polishing a metal substrate of the housing, an anodizing operation of forming an oxidized film including a plurality of pores, and a coloring operation of coloring by adsorbing an organic dye in the plurality of pores. The coloring operation may perform coloring by applying a conductivity enhancer together with the organic dye.

In an electronic device including a glossy housing according to an embodiment of the disclosure, the housing may include a metal substrate and an anodized layer formed by overlapping the metal substrate. The anodized layer may include a pore wall including a plurality of pores, and an organic dye injected to the plurality of pores and a conductivity enhancer of PH6 or more and PH8 or less, and the housing may have a value L* 22 or less in a CIE L*a*b* color space.

### [Brief Description of the Drawings]

FIG. 1 is a block diagram illustrating an electronic device in a network environment according to an embodiment of the disclosure;
FIG. 2 is a front perspective view illustrating an electronic device according to an embodiment of the disclosure;
FIG. 3 is a rear perspective view illustrating an electronic device according to an embodiment of the disclosure;
FIG. 4 is an exploded perspective view illustrating an electronic device according to an embodiment of the disclosure;
FIG. 5 is a flowchart illustrating a pre-processing process and an anodizing process according to an embodiment of the disclosure;
FIG. 6 is a view illustrating a cross section of a housing according to an embodiment of the disclosure;
FIG. 7 is a graph illustrating a relationship between coloring time and brightness in a conventional electronic device;
FIG. 8 is a graph illustrating a variation in electric potential value according to application of a conductivity enhancer;
FIG. 9A is a graph illustrating comparison in black dye brightness between a conventional electronic device and a conductivity enhancer-added electronic device according to the present invention;
FIG. 9B is a graph illustrating comparison in red-green-blue (RGB) values between a conventional electronic device and a conductivity enhancer-added electronic device according to the present invention;
FIG. 10A is a graph illustrating a variation in electric potential when non-removed acid is mixed with coloring dye particles in a conventional electronic device;
FIG. 10B is a graph illustrating a variation in electric potential according to the added amount of a conductivity enhancer when non-removed acid is mixed with coloring dye particles;
FIG. 10C is a view illustrating comparison between the brightness of a housing colored by a coloring operation according to an embodiment of the disclosure, the brightness of a housing in which a non-removed acid is further mixed, and the brightness of a housing in which a conductivity enhancer is further mixed according to an embodiment of the present invention;
FIG. 11A is a graph illustrating analysis of a housing colored with dye particles according to a conventional electronic device by a GDOES method;
FIG. 11B is a graph illustrating analysis of a housing colored with coloring dye particles according to an embodiment of the present invention by a GDOES method; and
FIG. 11C is a graph illustrating comparison between coloring dye particles according to FIG. 11A and coloring dye particles according to FIG. 11B.

### [Mode for Carrying out the Invention]

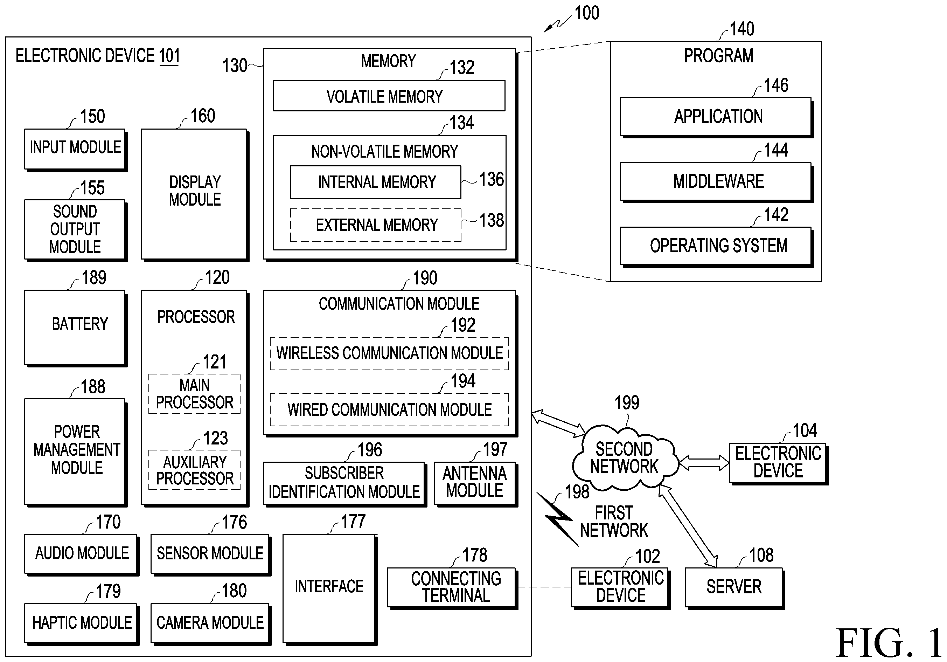

FIG. 1 is a block diagram illustrating an electronic device 101 in a network environment 100 according to an embodiment.

Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. **In** an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module may include an antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to an embodiment, the antenna module 197 may form a mmWave antenna module. According to an embodiment, the mm Wave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or health-care) based on 5G communication technology or IoT-related technology.

The electronic device according to an embodiment of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that an embodiment of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

An embodiment as set forth herein may be implemented as software (e.g., the program) including one or more instructions that are stored in a storage medium (e.g., internal memory or external memory) that is readable by a machine (e.g., the electronic device). For example, a processor (e.g., the processor) of the machine (e.g., the electronic device) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to an embodiment of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to an embodiment, each component (e.g., a module or a program) of the above-described components may include a single entity or multiple entities. Some of the plurality of entities may be separately disposed in different components. According to an embodiment, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to an embodiment, operations performed by the module, the program, or another component may be carried out sequentially, in parallel, repeatedly, or heuristically, or one or more of the operations may be executed in a different order or omitted, or one or more other operations may be added.

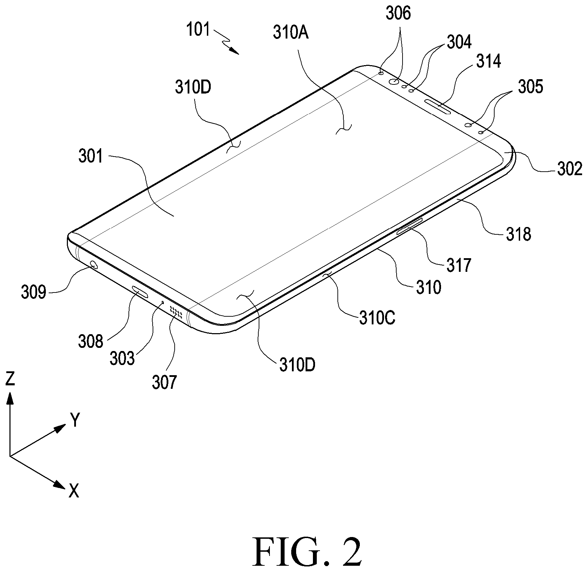

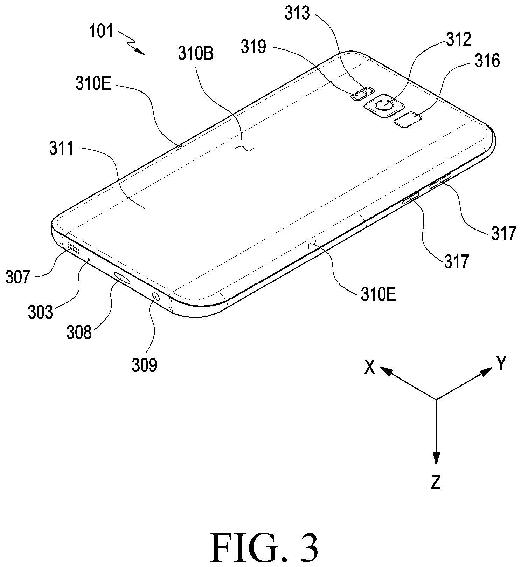

FIG. 2 is a front perspective view illustrating an electronic device 101 according to an embodiment of the disclosure. FIG. 3 is a rear perspective view illustrating an electronic device 101 according to an embodiment of the disclosure.

Referring to FIGS. 2 and 3, according to an embodiment, an electronic device 101 may include a housing 310 with a first (or front) surface 310A, a second (or rear) surface 310B, and a side surface 310C surrounding a space between the first surface 310A and the second surface 310B. According to another embodiment (not shown), the housing 310 may denote a structure forming part of the first surface 310A, the second surface 310B, and the side surface 310C of FIG. 2. According to an embodiment, at least part of the first surface 310A may have a substantially transparent front plate 302 (e.g., a glass plate or polymer plate including various coat layers). The second surface 310B may be formed of a substantially opaque rear plate 311. The rear plate 311 may be formed of, e.g., laminated or colored glass, ceramic, polymer, metal (e.g., aluminum, stainless steel (STS), or magnesium), or a combination of at least two thereof. The side surface 310C may be formed by a side bezel structure (or a "side member") 318 that couples to the front plate 302 and the rear plate 311 and includes a metal and/or polymer. According to an embodiment, the rear plate 311 and the side bezel plate 318 may be integrally formed together and include the same material (e.g., a metal, such as aluminum).

In the embodiment illustrated, the front plate 302 may include two first regions 310D, which seamlessly and bendingly extend from the first surface 310A to the rear plate 311, on both the long edges of the front plate 302. In the embodiment (refer to FIG. 3) illustrated, the rear plate 311 may include two second regions 310E, which seamlessly and bendingly extend from the second surface 310B to the front plate, on both the long edges. According to an embodiment, the front plate 302 (or the rear plate 311) may include only one of the first regions 310 (or the second regions 310E). Alternatively, the first regions 310D or the second regions 301E may partially be excluded. According to an embodiment, at side view of the electronic device 101, the side bezel structure 318 may have a first thickness (or width) for sides that do not have the first regions 310D or the second regions 310E and a second thickness, which is smaller than the first thickness, for sides that have the first regions 310D or the second regions 310E.

According to an embodiment, the electronic device 101 may include at least one or more of a display 301, audio modules 303, 307, and 314, sensor modules 304, 316, and 319, camera modules 305, 312, and 313, key input devices 317, a light emitting device 306, and connector holes 308 and 309. According to an embodiment, the electronic device 101 may exclude at least one (e.g., the key input device 317 or the light emitting device 306) of the components or may add other components.

According to an embodiment, the display 301 may be exposed through, e.g., a majority portion of the front plate 302. According to an embodiment, at least a portion of the display 301 may be exposed through the front plate 302 forming the first surface 310A and the first regions 310D of the side surface 310C. According to an embodiment, the edge of the display 301 may be formed to be substantially the same in shape as an adjacent outer edge of the front plate 302. According to another embodiment (not shown), the interval between the outer edge of the display 301 and the outer edge of the front plate 302 may remain substantially even to give a larger area of exposure the display 301.

According to an embodiment (not shown), the screen display region of the display 301 may have a recess or opening in a portion thereof, and at least one or more of the audio module 314, sensor module 304, camera module 305, and light emitting device 306 may be aligned with the recess or opening. According to another embodiment (not shown), at least one or more of the audio module 314, sensor module 304, camera module 305, fingerprint sensor 316, and light emitting device 306 may be included on the rear surface of the screen display area of the display 301. According to an embodiment (not shown), the display 301 may be disposed to be coupled with, or adjacent, a touch detecting circuit, a pressure sensor capable of measuring the strength (pressure) of touches, and/or a digitizer for detecting a magnetic field-type stylus pen. According to an embodiment, at least part of the sensor modules 304 and 319 and/or at least part of the key input device 317 may be disposed in the first regions 310D and/or the second regions 310E.

According to an embodiment, the audio modules 303, 307, and 314 may include a microphone hole 303 and speaker holes 307 and 314. A microphone for acquiring external sounds may be disposed in the microphone hole 303. In some embodiments, a plurality of microphones may be disposed to detect the direction of the sound. The speaker holes 307 and 314 may include an external speaker hole 307 and a phone receiver hole 314. In an embodiment, the speaker holes 307 and 314 and the microphone hole 303 may be implemented as a single hole, or speakers may be included without the speaker holes 307 and 314 (e.g., piezo speakers).

According to an embodiment, the sensor modules 304, 316, and 319 may generate an electrical signal or data value corresponding to an internal operating state or external environmental state of the electronic device 101. The sensor modules 304, 316, and 319 may include a first sensor module 304 (e.g., a proximity sensor) and/or a second sensor module (not shown) (e.g., a fingerprint sensor) disposed on the first surface 310A of the housing 310 and/or a third sensor module 319 (e.g., a heart-rate monitor (HRM) sensor) and/or a fourth sensor module 316 (e.g., a fingerprint sensor) disposed on the second surface 310B of the housing 310. The fingerprint sensor may be disposed on the second surface 310B as well as the first surface 310A (e.g., the display 301) of the housing 310. The electronic device 101 may further include sensor modules not shown, e.g., at least one of a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor 304.

According to an embodiment, the camera modules 305, 312, and 313 may include a first camera device 305 disposed on the first surface 310A of the electronic device 101, and a second camera device 312 and/or a flash 313 disposed on the second surface 310B. The camera modules 305 and 312 may include one or more lenses, an image sensor, and/or an image signal processor. The flash 313 may include, e.g., a light emitting diode (LED) or a xenon lamp. According to an embodiment, two or more lenses (an infrared (IR) camera, a wide-angle lens, and a telescopic lens) and image sensors may be disposed on one surface of the electronic device 101.

According to an embodiment, the key input device 317 may be disposed on the side surface 310C of the housing 310. According to another embodiment, the electronic device 101 may exclude all or some of the above-mentioned key input devices 317 and the excluded key input devices 317 may be implemented in other forms, e.g., as soft keys, on the display 301. According to an embodiment, the key input device 317 may include the sensor module 316 disposed on the second surface 310B of the housing 310.

According to an embodiment, the light emitting device 306 may be disposed on, e.g., the first surface 310A of the housing 310. The light emitting device 306 may provide, e.g., information about the state of the electronic device 101 in the form of light. According to an embodiment, the light emitting device 306 may provide a light source that interacts with, e.g., the camera module 305. The light emitting device 306 may include, e.g., a light emitting diode (LED), an infrared (IR) LED, or a xenon lamp.

The connector holes 308 and 309 may include a first connector hole 308 for receiving a connector (e.g., a universal serial bus (USB) connector) for transmitting or receiving power and/or data to/from an external electronic device and/or a second connector hole 309 (e.g., an earphone jack) for receiving a connector for transmitting or receiving audio signals to/from the external electronic device.

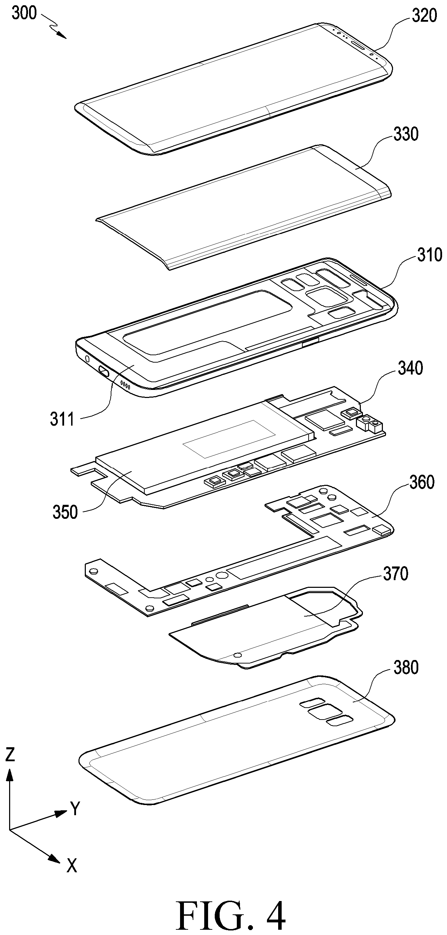

FIG. 4 is an exploded perspective view illustrating an electronic device 101 according to an embodiment.

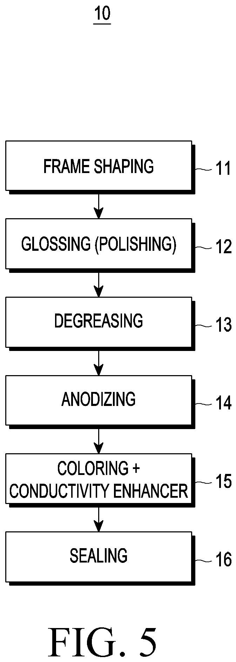

Referring to FIG. 4, an electronic device 101 (e.g., the electronic device 101 of FIGS. 1 to 4) may include a side bezel structure 331, a first supporting member 332 (e.g., a bracket), a front plate 320, a display 330, a printed circuit board (PCB) 340, a battery 350, a second supporting member 360 (e.g., a rear case), an antenna 370, and a rear plate 380. According to an embodiment, the electronic device 101 may exclude at least one (e.g., the first supporting member 332 or the second supporting member 360) of the components or may add other components. At least one of the components of the electronic device 101 may be the same or similar to at least one of the components of the electronic device 101 of FIG. 4 or 5 and no duplicate description is made below.

According to an embodiment, the first supporting member 332 may be disposed inside the electronic device 101 to be connected with the side bezel structure 331 or integrated with the side bezel structure 331. The first supporting member 332 may be formed of, e.g., a metal and/or non-metallic material (e.g., polymer). The display 330 may be joined onto one surface of the first supporting member 332, and the printed circuit board 340 may be joined onto the opposite surface of the first supporting member 311. A processor, memory, and/or interface may be mounted on the printed circuit board 340. The processor may include one or more of, e.g., a central processing unit, an application processor, a graphic processing device, an image signal processing, a sensor hub processor, or a communication processor.

According to an embodiment, the memory may include, e.g., a volatile or non-volatile memory.

According to an embodiment, the interface may include, e.g., a high definition multimedia interface (HDMI), a universal serial bus (USB) interface, a secure digital (SD) card interface, and/or an audio interface. The interface may electrically or physically connect, e.g., the electronic device 101 with an external electronic device and may include a USB connector, an SD card/multimedia card (MMC) connector, or an audio connector.

According to an embodiment, the battery 350 may be a device for supplying power to at least one component of the electronic device 101. The battery 189 may include, e.g., a primary cell which is not rechargeable, a secondary cell which is rechargeable, or a fuel cell. At least a portion of the battery 350 may be disposed on substantially the same plane as the printed circuit board 340. The battery 350 may be integrally or detachably disposed inside the electronic device 101.

According to an embodiment, the antenna 370 may be disposed between the rear plate 380 and the battery 350. The antenna 370 may include, e.g., a near-field communication (NFC) antenna, a wireless charging antenna, and/or a magnetic secure transmission (MST) antenna. The antenna 370 may perform short-range communication with, e.g., an external device or may wirelessly transmit or receive power necessary for charging. According to an embodiment, an antenna structure may be formed by a portion or combination of the side bezel structure 331 and/or the first supporting member 332.

According to an embodiment of the disclosure, the electronic device may include a plurality of antenna modules 390. For example, some of the plurality of antenna modules 390 may be implemented to transmit or receive radio waves with different characteristics (referred to as radio waves of frequency bands A and B) to implement MIMO. As another example, some of the plurality of antenna modules 390 may be configured to transmit or receive radio waves with substantially the same characteristic (referred to as radio waves of frequencies A1 and A2 in frequency band A) to implement diversity. As another example, some of the plurality of antenna modules 390 may be configured to transmit or receive radio waves with substantially the same characteristic (referred to as radio waves of frequencies B1 and B2 in frequency band B) to implement diversity. According to an embodiment, two antenna modules may be included. Alternatively, the electronic device 101 may include four antenna modules to implement both MIMO and diversity. According to another embodiment, the electronic device 101 may include only one antenna module 390.

According to an embodiment, given the transmission and reception nature of radio waves, when one antenna module is disposed in a first position of the printed circuit board 340, another antenna module may be disposed in a second position, which is separated from the first position, of the printed circuit board 340. As another example, one antenna module and another antenna module may be disposed considering the distance therebetween depending on diversity characteristics.

According to an embodiment, at least one antenna module 390 may include a wireless communication circuit to process radio waves transmitted or received in an ultra-high frequency band (e.g., 6GHz or more and 300GHz or less). The conductive plate of the at least one antenna module 390 may be formed of a dipole-structured conductive plate extending in one direction or a patch-type radiating conductor. A plurality of conductive plates may be arrayed to form an antenna array. A chip (e.g., an integrated circuit (IC) chip) in which part of the wireless communication circuit is implemented may be disposed on the opposite surface of the surface where the conductive plate is disposed or on one side of the area where the conductive plate is disposed and may be electrically connected with the conductive plate via a line which is formed of a printed circuit pattern.

According to an embodiment, at least one of the housing 310, the supporting member (e.g., the first supporting member 332 and/or the second supporting member 360), the side bezel structure 331, the front plate 320, and/or the rear plate 380 of the electronic device 101 may at least partially include a metallic material. For example, at least some of the housing 310, the supporting member (e.g., the first supporting member 332 and/or the second supporting member 360), the side bezel structure 331, the front plate 320, and/or the rear plate 380 of the electronic device 101 may be manufactured by the pre-processing process and the anodizing process 10 of FIG. 5, which are described below. In the illustrated embodiment, the housing 310, the supporting member (e.g., the first supporting member 332 and/or the second supporting member 360), the side bezel structure 331, the front plate 320, and/or the rear plate 380 may be at least partially visually exposed to the outside of the electronic device 101.

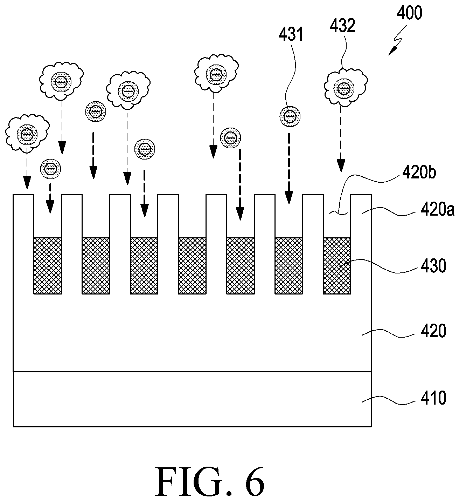

FIG. 5 is a flowchart illustrating a pre-processing process and an anodizing process 10 according to an embodiment of the disclosure. FIG. 6 is a view illustrating a cross section of a housing 400 according to an embodiment of the disclosure.

According to an embodiment, the housing 400 of FIG. 6 may be provided as at least one of the housing 310, the first supporting member 332 (e.g., a bracket), the second supporting member 360 (e.g., a rear case), the side bezel structure 331, the front plate 320, and/or the rear plate 380 of the electronic device 101 of FIGS. 2 to 4. The housing 400 may be provided as an external component such as a side structure or a rear plate.

According to an embodiment, referring to FIG. 6, the housing 400 may include a metal substrate 410 and an anodized layer 420 formed to overlap the metal substrate 410. The anodized layer 420 may include a pore wall 420a including a plurality of pores 420b, and coloring particles 430 including an organic dye 431 and a conductivity enhancer 432 injected to the plurality of pores 420b.

According to an embodiment, the housing 400 may be glossy. In general, the gloss of the surface of the housing 400 may be measured according to a surface gloss measurement method. For example, the gloss of the housing 400 may be larger than or equal to 40 GU under a condition of a measurement angle of 60 degrees. However, the gloss of the housing 400 is not limited to the above-described embodiment, and various changes may be made to the design.

According to an embodiment, the metal substrate 410 of the housing 400 may include all metal exterior materials capable of anodizing. For example, the metal of the metal substrate 410 may include all structures of being capable of anodizing to color by adsorbing the dye in the pores. For example, the metal may be aluminum or an aluminum alloy. However, the type of the metal is not limited to the above-described embodiment, and the design may be freely changed.

According to an embodiment, referring to FIG. 5, the pre-processing process and the anodizing process 10 may include an operation 11 of processing the shape of the frame of the metal substrate 410, a glossing operation 12, a degreasing operation 13, an anodizing operation 14, a coloring operation 15, and/or a sealing operation 16.

According to an embodiment, the operation 11 of processing the shape of the frame of the metal substrate 410 is an operation of manufacturing a frame of a metal material (e.g., aluminum, magnesium, and/or titanium) into a designed component shape, and process or manufacture the metal material into the metal substrate 410 having a designed shape through processes such as extrusion, press, die casting, and/or cutting (e.g., computer numerical control (CNC) processing). The metal substrate 410 may have a substantially flat plate shape, and may at least partially include a curved surface or include a hole, a recess, and/or a rib or partition according to the specifications and shapes required for a product to be actually manufactured (e.g., the electronic device 101 of FIGS. 2 to 4).

According to an embodiment, the glossing operation 12 is a process of increasing the gloss of the surface of the manufactured metal substrate 410, and may form a glossy exterior by performing polishing for glossing. For example, the surface roughness of the metal substrate 410 may be decreased through physical or chemical polishing. According to an embodiment, the polishing operation may be omitted, or may be replaced with a process (e.g., sand blasting) of decreasing gloss by increasing surface roughness. For example, a polishing operation or a sand blasting process as a process for adjusting gloss or surface roughness on the surface of the metal substrate 410 may be selectively performed according to the specifications required in a product to be actually manufactured. In an embodiment, the surface roughness adjusted through the polishing operation or the sand blasting process may be recognized by the user's tactile sense.

According to an embodiment, the degreasing operation 13 may be an operation of removing dust and/or foreign substances that have not been removed in the processing operation 11 and/or the glossing operation 12.

According to an embodiment, the anodizing operation 14 is a process of increasing the reliability of the metal substrate 410 or the exterior component, and may form the anodized layer 420 the surface of the metal substrate 410. The anodized layer 420 may increase the durability or reliability of the metal substrate 410 by, e.g., increasing the strength (e.g., hardness) on the surface of the metal substrate 410 or preventing corrosion of the metal substrate 410 due to an external environment. The anodizing operation 14 is a process of forming a porous oxide film and may grow the anodized layer 420 on the surface of the metal substrate 410, e.g., by applying a voltage with the metal substrate 410 deposited in an electrolyte solution (or electrolyte) including at least one of sulfuric acid, hydroxyl acid, oxalic acid, and/or chromic acid. According to an embodiment, the applied voltage, temperature, and/or deposition time may be adjusted according to the use of the film. For example, the applied voltage may be about 5 V or more and 40 V or less. For example, the deposition time may be about 10 minutes or more and 3 hours or less. For example, the temperature of the electrolyte may be applied within a range of about 5 degrees to 30 degrees.

According to an embodiment, referring to FIG. 6, after the anodizing operation 14, the housing 400 may further include an anodized layer 420 formed on the surface of the metal substrate 410. The anodized layer 420 may include, e.g., a pore wall 420a including a plurality of air pores 420b, and may be easily colored. Here, 'easily colored' may be understood as it being easier to color the anodized layer 420 than to color the material on which the anodized layer 420 is not formed or the surface of the metal substrate 410.

According to an embodiment, after the anodized layer 420 including the porous oxide film is formed, the coloring operation 15 of coloring by adsorbing the coloring dye particles 430 in the plurality of air pores 420b may be performed. The coloring operation 15 may be a process of dyeing or coloring the surface of the metal substrate 410, e.g., the anodized layer 420, in a designated color. According to an embodiment, the coloring operation 15 may include an immersion method and/or an electrolytic coloring method. The immersion method may be a method of realizing a color by diffusing or adsorbing the coloring dye particles 430 to the anodized layer 420 by depositing the metal substrate 410 in a solution in which the coloring dye particles 430 are added and/or dissolved. The electrolytic coloring method may be a method of coloring in a metal salt electrolyte by applying a current. According to an embodiment of the present invention, the coloring operation 15 may perform coloring using an immersion method. However, the coloring method is not limited to the above-described embodiment, and various changes may be made to the design.

According to an embodiment, the coloring dye particles 430 may use an organic dye 431 capable of implementing various colors. This is a method of dissolving the organic dye 431 in water and then dipping the product to color it. In order to implement a desired color, dyes of various colors may be mixed and used, or only a single dye may be used. Color brightness may be adjusted by the dye concentration and deposition time.

According to an embodiment, in the coloring operation 15, the organic dye 431 together with the conductivity enhancer 432 may be dissolved to perform coloring. When the conductivity enhancer 432 is added, it is possible to implement an exterior in a deeper and more vivid color than a coloring operation that increases the dye concentration or increases the coloring time. A detailed description of the addition of the conductivity enhancer 432 is described below.

According to an embodiment, the anodized layer 420 may be colored by the coloring operation 15. For example, the organic dye 431 may be diffused or adsorbed into the anodized layer 420 or received into the plurality of air pores 420b, thereby implementing a designated color on the surface of the metal substrate 410.

According to an embodiment, the sealing operation 16 of sealing the plurality of air pores 420b of the activated anodized layer 420 may be performed. The sealing operation is a process of preventing the coloring dye particles 430 from being separated. For example, the coloring dye particles 430 may be substantially maintained in the anodized layer 420 by sealing the plurality of air pores 420b. The sealing operation 16 includes a metal salt treatment method in which sealing is performed using a metal salt and a non-metal salt treatment method in which sealing is performed using an organic material, and a hydrated sealing treatment using water and water vapor. By performing the sealing operation 16, discoloration of the metal substrate 410 may be suppressed or prevented.

Hereinafter, the coloring operation 15 is described in detail.

According to an embodiment, when coloring is performed by the immersion method in the coloring operation 15, coloring may be promoted so that many coloring dye particles 430 may be diffused and absorbed in the plurality of pores 420b for a short time. For example, if a desired color is to be implemented in an electronic device (e.g., the electronic device 101 of FIG. 2), the processed metal substrate 410 may be anodized and then immersed in a coloring tank in which the coloring dye particles 430 are dissolved. The anodized material may be electrically positive (+), and the organic dye 431 may have negative (-) charge. Due to this electrical property, the organic dye 431, which is a (-)ion, is diffused and adsorbed to the plurality of pores 420b in the film of the (+) pole, and then the coloring dye particles 430 in the plurality of pores 420b are stabilized by the sealing operation 16, thereby obtaining a desired color film. The adsorption amount of the organic dye 431 may vary depending on the concentration of the dye and/or the product deposition time.

According to an embodiment of a conventional electronic device, the coloring operation 15 may be performed by increasing the concentration of the coloring dye particles 430 in order to implement the housing 400 having a deep and vivid color. In the case of the conventional electronic device, the concentration of the coloring dye particles 430 during the coloring operation 15 may be usable, e.g., within a range of about 20 g/L or less. In the case of the conventional electronic device, the deposition time in the coloring operation 15 may be applicable, e.g., within a range of about 5 seconds to 20 minutes. When the concentration of the coloring dye particles 430 is applied to the maximum value or more to implement the housing 400 having a deep and vivid color, the coloring dye particles 430 are difficult to dissolve, and the undissolved coloring dye particles 430 may be precipitated or floated in water, which may rather interfere with coloring or deteriorate quality.

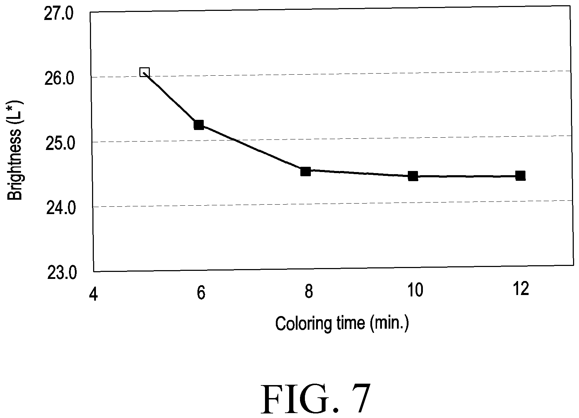

FIG. 7 is a graph illustrating a relationship between coloring time and brightness in a conventional electronic device.

According to an embodiment, the coloring time may be increased to implement the housing 400 having a deep and vivid color. Referring to FIG. 7, it may be identified that the adsorption amount of the coloring dye particles 430 decreases in brightness as the coloring time increases, but the change in the decrease in brightness slows under conditions of 8 minutes or more. This may mean that the adsorption amount of the coloring dye particles 430 slows under conditions of a predetermined time or more. It may mean that even if the concentration of the coloring dye particles 430 is increased and the coloring time is increased, there is a limit to implementing a deep color. According to an embodiment, the method of increasing the coloring time may cause an increase in cost due to an increase in the process time. Here, the brightness may be expressed as CIE color table L* value. The closer the L* value is to 100, the brighter (white) the color is. The closer the L* value is to 0, the deeper and darker (black) the color is.

According to an embodiment of the conventional electronic device, in order to implement the housing 400 having a deep and vivid color, the temperature of the anodizing electrolyte may be increased when forming the anodized film. When the temperature of the electrolyte solution is increased, the size of the plurality of pores 420b may be increased, but the anodized layer 420 having a high temperature may not secure reliability due to its weak durability. For example, when the surface of the anodized layer 420 is modified, such as by a method of designing a shape of a surface having low light reflectance by making a fine bend on an aluminum material or forming a fine bend on the anodized layer 420, etching is required to be applied to eh surface of the aluminum material and/or the anodized layer 420, making it limited to matte housings while it is impossible to implement it on glossy housings. When the anodized layer 420 is etched, it may be difficult to secure reliability due to poor film durability.

According to an embodiment of the present invention, in order to overcome the above limitations and implement a deep color, the coloring dye particles 430 including the conductivity enhancer 432 together with the organic dye 431 are applied in the coloring process. The conductivity enhancer 432 may increase the energy of the coloring dye particles 430 to easily diffuse and stably adsorb the coloring dye particles 430 into the pores in the anodized film.

According to an embodiment, the conductivity enhancer 432 may include all materials capable of affecting the conductivity enhancement of the coloring dye particles 430. For example, it may include an alkali salt. For example, it may include a weak alkali salt of pH6 or more and pH8 or less. For example, the conductivity enhancer 432 may include gluconate.

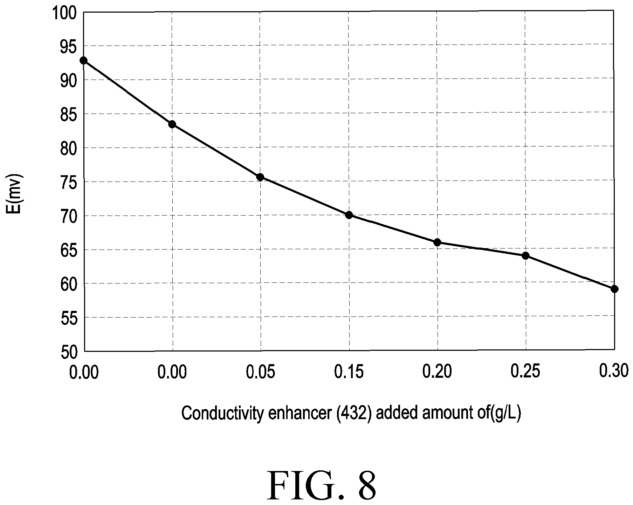

FIG. 8 is a graph illustrating a variation in electric potential value according to application of a conductivity enhancer 432. Electric potential is electrical potential energy for a unit charge, which refers to the work energy required to transfer the charge from a reference point to another place. According to an embodiment, when the conductivity enhancer 432 is added to the coloring dye particles 430 including the organic dye 431, the electric potential value may vary.

Referring to FIG. 8, when the conductivity enhancer 432 is not applied (e.g., when the added amount of the conductivity enhancer is 0.00g/L), it may be identified that the electric potential value is the highest. The high electric potential value may mean that a large amount of energy is required for the coloring dye particles 430 which are negative (-) to diffuse into the plurality of pores 420b of the anodized layer 420 which is positive (+). Referring to FIG. 8, it may be identified that the electric potential value decreases as the conductivity enhancer 432 is added. This may mean that the coloring dye particles 430, which are (-) to which the conductivity enhancer 432 is added, may be easily diffused into the plurality of pores 420b of the anodized layer 420 with only a small energy. When the conductivity enhancer 432 is not added in the conventional electronic device, it may be difficult for all of the coloring dye particles 430 to diffuse into the anodized layer 420. When the conductivity enhancer 432 according to an embodiment is added, the coloring dye particles 430 may be easily diffused with less energy. As the conductivity enhancer 432 is added, the coloring dye particles 430, which are difficult to diffuse, may be easily diffused, thereby increasing the coloring speed and absorbing many coloring dye particles 430 into the plurality of pores 420b, so that a vivid and deep color may be implemented.

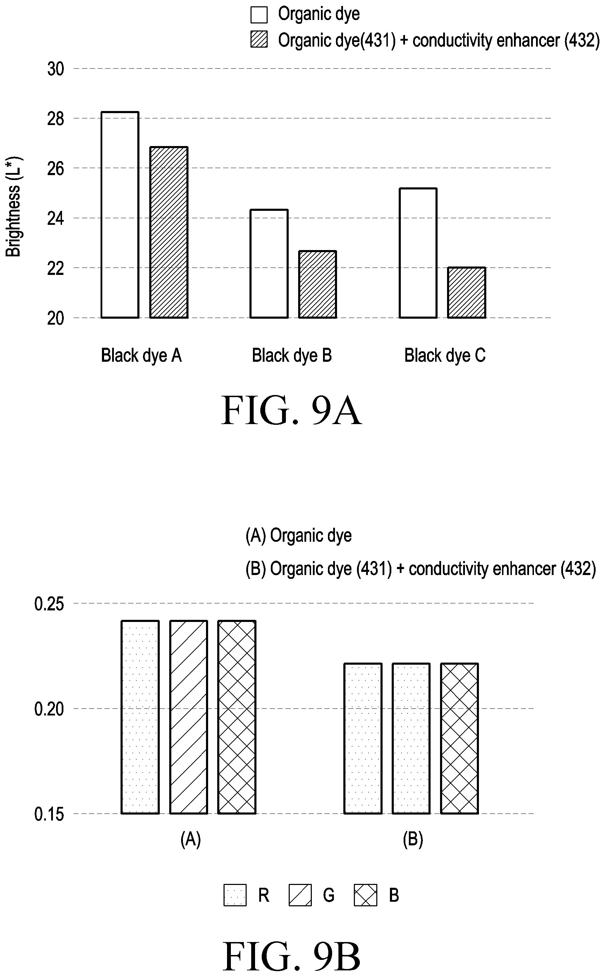

FIG. 9A is a graph illustrating comparison in black dye brightness between a conventional electronic device and a conductivity enhancer 432-added electronic device 101 according to the present invention. FIG. 9B is a graph illustrating comparison in red-green-blue (RGB) values between a conventional electronic device and a conductivity enhancer 432-added electronic device 101 according to the present invention.

According to an embodiment, referring to FIG. 9A, the depth and sharpness of the color of the housing 400 are shown as the brightness (L*) value. After preparing the same series of black dyes (e.g., black dye A, black dye B, and black dye C in FIG. 9) produced by different companies, the coloring dye particles 430 were dissolved at a maximum concentration (20g/L) within a range that may be dissolved, and a maximum time (20 minutes) was applied as the coloring time within a range suitable for mass production. The housing 400 of the electronic device had a glossy surface, and the same conditions were applied except for whether or not to apply the conductivity enhancer 432. As a result of the experiment, each coloring dye particle 430 had a different brightness (L*) value, which is the depth even under the same conditions, and when the conductivity enhancer 432 was applied, it exhibited a lower brightness value than that of the color when only the conventional organic dye 431 was applied under all the conditions. This indicates that the color depth of the product exterior may be enhanced by the effect of the conductivity enhancer 432. In an embodiment of the present invention, the color depth of the glossy high-gloss housing 400 may have a value of brightness(L*)=22.0 or less.

According to an embodiment, referring to FIG. 9B, the L*, a*, b* value in the CIE color table may be converted into a red-green-blue (RGB) value indicating red, green, and blue which are the primary colors of light so as to compare the degrees of white and black. For example, RGB(255,255,255) may mean white in which all of the red, green, and blue are the brightest. For example, RGB(0,0,0) may mean black in which no light is present. The closer each value of R, G, and B is to '0', the closer it may be to pure black. Referring to FIG. 9B, the left graph shows each of the RGB values of the conventional electronic device A including the organic dye, and the right graph shows each of the RGB values of the glossy housing 400 according to an embodiment of the present invention which includes the organic dye 431 and the conductivity enhancer 432. According to an embodiment, it may be identified that the RGB value of the glossy housing 400 according to an embodiment of the present invention is lower than the RGB value of the conventional electronic device A. For example, the RGB value of the glossy housing 400 according to an embodiment of the present invention may be 0.20 or more and 0.24 or less. For example, the RGB value of the glossy housing 400 according to an embodiment of the present invention may be RGB(0.22,0.22,0.22) or less. For example, the RGB value of the conventional electronic device A may be 0.23 or more and 0.26 or less. For example, the RGB value of the conventional electronic device A may be RGB(0.24,0.24,0.24) or more. This may mean that it is closer to pure black under the conditions where the conductivity enhancer 432 than under the general conditions.

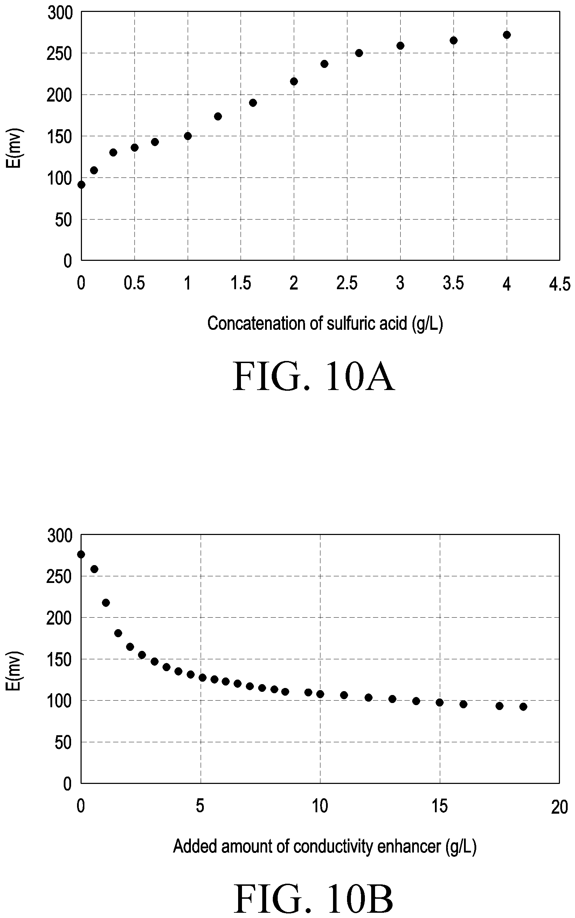

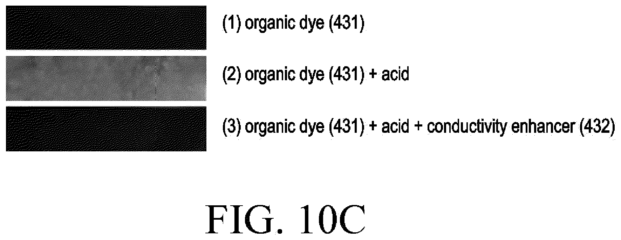

FIG. 10A is a graph illustrating a variation in electric potential when non-removed acid is mixed with coloring dye particles 430 in a conventional electronic device. FIG. 10B is a graph illustrating a variation in electric potential according to the added amount of a conductivity enhancer when non-removed acid is mixed with coloring dye particles 430. FIG. 10C is a view illustrating comparison between the brightness of a housing 400 colored by a coloring operation 15 according to an embodiment of the disclosure, the brightness of a housing in which a non-removed acid is further mixed, and the brightness of a housing 400 in which a conductivity enhancer 432 is further mixed according to an embodiment of the present invention.

According to an embodiment, the coloring operation 15 may be performed after the anodizing process in a manner of immersing the product in an acid solution (electrolyte solution), such as sulfuric acid, hydroxyl acid, and/or chromic acid to form micropores and then adsorbing the dye into the pores to implement a color. After the anodizing operation 14, the acid solution may not be completely removed but may remain in the product and be mixed into the coloring dye particles 430. Typically, there is a process of removing acid remaining in the product through 2 to 3 steps of washing after the anodizing process, but in the case of a complex electronic device 101 shape as shown in FIGS. 2 and 3, it may be difficult to remove the remaining acid. To remove the acid remaining in the product, a washing process may be added or the washing process time may be increased but, in such a case, the activity level of the anodized layer 420 may be decreased, making it difficult to obtain a desired quality of color. When the acid remaining in the electronic device 101 is mixed into the coloring dye particles 430 without being removed, the electric potential may increase. Referring to FIG. 10A, as the concatenation of the mixed acid (e.g., sulfuric acid) increases, the electric potential of the coloring dye particles 430 may increase. As the H+ ions are increased by the mixed acid, diffusion of the (-) ions which are the coloring dye particles 430 into the plurality of pores 420b may be disturbed. When the acid remaining in the electronic device 101 is mixed into the coloring dye particles 430 without being removed, the coloring power may be decreased, or it may be difficult to implement a deep and vivid color by the coloring.

Referring to FIG. 10B, it may be identified that the electric potential which was increased as the acid was mixed into the coloring dye particles 430 is decreased as the added amount of the conductivity enhancer 432 increases. The conductivity enhancer 432 may offset the H+ ions in the acid-mixed coloring dye particles 430. This facilitates management of the coloring dye particles 430.

Referring to FIG. 10C, it may be identified that coloring is performed in the same manner as the conventional one (e.g., reference numeral (1)) when coloring is performed in the dye tank in which the electric potential value which was increased by the mixed acid (e.g., reference numeral (2)) is recovered into the original electric potential value by adding the conductivity enhancer 432 (e.g., reference numeral (3)).

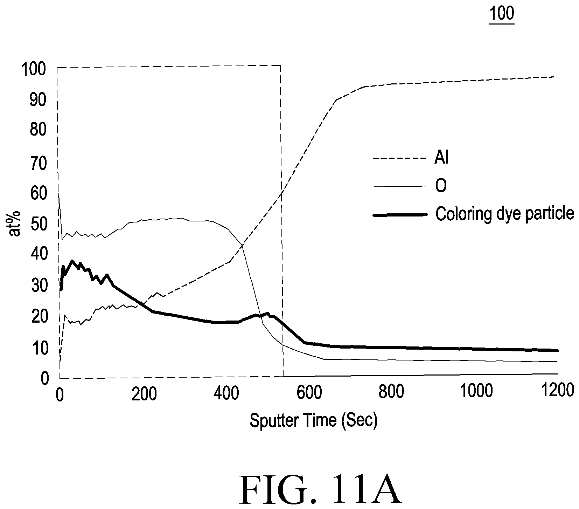

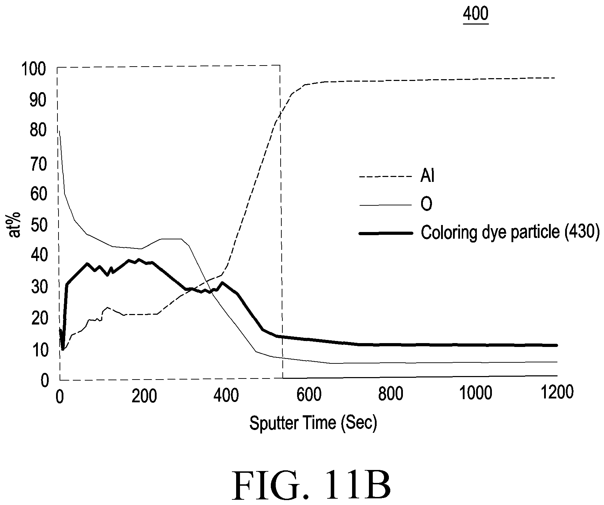

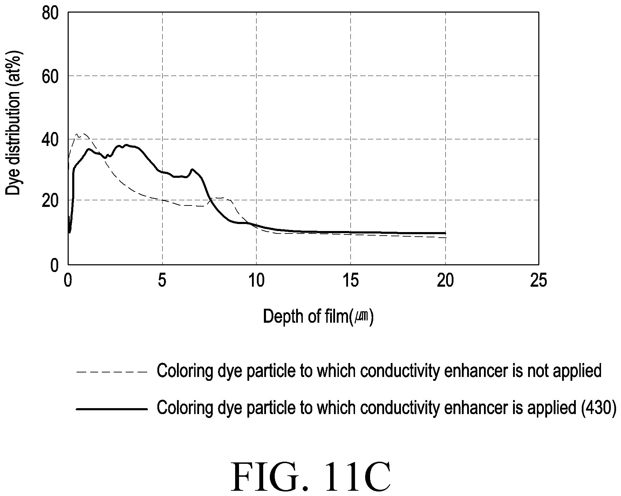

FIG. 11A is a graph illustrating analysis of a housing colored with dye particles according to a conventional electronic device by a GDOES method. FIG. 11B is a graph illustrating analysis of a housing 400 colored with coloring dye particles 430 according to an embodiment of the present invention by a GDOES method. FIG. 11C is a graph illustrating comparison between coloring dye particles according to FIG. 11A and coloring dye particles 430 according to FIG. 11B.

According to an embodiment, the glow-discharge optical emission spectroscopy (GDOES) analysis method is a quantitative analysis method using glow discharge, which is a spectroscopic analysis method that may analyze compositional changes from the surface to the cross-section along the depth direction. In the portion where the anodized layer 420 is formed (X-axis, Sputter Time: period of 0 to 500 sec), the dye adsorption amount and dye adsorption depth in an embodiment of the present invention may be compared with those in the conventional electronic device using dye (e.g., black dye) signals. It may be identified that when dye particles according to the conventional electronic device are used, the signal of the coloring dye particles 430 is high at the entrance of the anodized layer 420 and the signal is lowered toward a lower end portion. According to an embodiment of the present invention, it may be identified that when the coloring dye particles 430 are used, the dye signal is high throughout the upper and lower end portions of the anodized layer 420. It may be identified that the dye is adsorbed up to a depth of about 60% or more from the entrance of the anodized layer 420. Referring to FIG. 11c, it may be identified that the coloring dye particles 430 color, deeper, in the product to which the conductivity enhancer 432 is applied than under the condition where the conductivity enhancer 432 is not applied. Therefore, when the conductivity enhancer 432 is applied, it is possible to implement an exterior in a deep and vivid color as compared with the conventional coloring operation, by diffusing and/or adsorbing more dye particles into the pores.

As an aluminum material surface treatment method, anodizing may implement various colors using dye and implement various colors by mixing various dyes or under coloring conditions, but are subject to some restrictions in implementing a deep color of brightness(L*) 24 or less.

According to an embodiment of the present invention, there may be provided an electronic device including an aluminum frame exterior in a deep and vivid color by applying a conductivity enhancer together with an organic dye in the coloring step of the anodizing process of an aluminum frame.

According to an embodiment of the present invention, it is possible to implement a deep and vivid color in an aluminum frame while including a glossy aluminum frame exterior having a value of L* 22 or less in the CIE L*a*b* color space when applying a black color, thereby providing an exterior material for portable electronic devices in a deep and gorgeous color.

Objects of the disclosure are not limited to the foregoing, and other unmentioned objects would be apparent to one of ordinary skill in the art from the following description.

According to an embodiment of the present invention, there may be provided an electronic device including an aluminum frame exterior in a deeper and vivid color under the same anodizing conditions (applied voltage, coloring concatenation/temperature/time) by applying a conductivity enhancer together with an organic dye in the coloring step of the anodizing process of an aluminum frame.

According to an embodiment of the present invention, a conductivity enhancer is applied to implement a deep and vivid color on the glossy exterior. Therefore, it is possible to implement a deeper and more vivid color than that of the exterior implementable in the conventional art by enhancing the diffusion and adsorption of dye upon coloring.

Effects obtainable from the disclosure are not limited to the above-mentioned effects, and other effects not mentioned may be apparent to one of ordinary skill in the art from the following description.

In an electronic device including a glossy housing according to an embodiment of the disclosure, the housing may include a metal substrate and an anodized layer formed by overlapping the metal substrate. The anodized layer may include a pore wall including a plurality of pores and a coloring dye particle including a conductivity enhancer and an organic dye injected to the plurality of pores.

According to an embodiment, the coloring dye particle may have the dye adsorbed up to a depth of 60% or more of the anodized layer.

According to an embodiment, the conductivity enhancer may be a weak alkaline salt of pH 6 or more and PH 8 or less.

According to an embodiment, the housing may have a value of L* 22 or less in a CIE L*a*b* color space.

According to an embodiment, the housing may have a value of RGB(0.22,0.22,0.22) or less.

According to an embodiment, the housing may have a gloss of 40GU or more.

According to an embodiment, a speed at which the coloring dye particle spreads to the plurality of pores may increase as the conductivity enhancer is added.

According to an embodiment, a number of H+ ions incorporated in the coloring dye particle may decrease as the conductivity enhancer is added.

A method for manufacturing a glossy housing according to an embodiment of the disclosure may comprise a glossing operation for polishing a metal substrate of the housing, an anodizing operation of forming an oxidized film including a plurality of pores, and a coloring operation of coloring by adsorbing an organic dye in the plurality of pores. The coloring operation may perform coloring by applying a conductivity enhancer together with the organic dye.

According to an embodiment, after the anodizing operation, the housing may include the metal substrate and an anodized layer formed on a surface of the metal substrate.

According to an embodiment, the anodized layer may include a pore wall including a plurality of pores and a coloring dye particle including a conductivity enhancer and an organic dye injected to the plurality of pores.

According to an embodiment, the coloring dye particle may have the dye adsorbed up to a depth of 60% or more of the anodized layer.

According to an embodiment, the conductivity enhancer may be a weak alkaline salt of pH 6 or more and PH 8 or less.

According to an embodiment, the housing may have a value of L* 22 or less in a CIE L*a*b* color space.

According to an embodiment, the housing may have a value of RGB(0.22,0.22,0.22) or less.

According to an embodiment, the housing may have a gloss of 40GU or more.

According to an embodiment, a speed at which the coloring dye particle spreads to the plurality of pores may increase as the conductivity enhancer is added.

According to an embodiment, a number of H+ ions incorporated in the coloring dye particle may decrease as the conductivity enhancer is added.

According to an embodiment, the metal substrate may be at least one metal having a structure capable of adsorbing the coloring dye particle in the plurality of pores by being capable of anodizing.

In an electronic device including a glossy housing according to an embodiment of the disclosure, the housing may include a metal substrate and an anodized layer formed by overlapping the metal substrate. The anodized layer may include a pore wall including a plurality of pores, and a coloring dye particle including a conductivity enhancer of PH6 or more and PH8 or less and an organic dye injected to the plurality of pores. The housing may have a value of L*22 or less in a CIE L*a*b* color space.

It is apparent to one of ordinary skill in the art that the deep-colored housing 400 and the electronic device 101 including the same according to an embodiment of the disclosure as described above are not limited to the above-described embodiments and those shown in the drawings, and various changes, modifications, or alterations may be made thereto without departing from the scope of the disclosure.

## Claims

1. An electronic device (101 of FIG. 1) including a glossy housing (400 of FIG. 6), wherein the housing includes:
a metal substrate (410 of FIG. 6); and
an anodized layer (420 of FIG. 6) formed by overlapping the metal substrate, and wherein the anodized layer (420 of FIG. 6) includes:
a pore wall (420a of FIG. 6) including a plurality of pores (420b of FIG. 6); and
a coloring dye particle (430 of FIG. 6) including a conductivity enhancer (432 of FIG. 6) and an organic dye (431 of FIG. 6) injected to the plurality of pores.

2. The electronic device of claim 1, wherein the coloring dye particle has the dye adsorbed up to a depth of 60% or more of the anodized layer.

3. The electronic device of claim 1, wherein the conductivity enhancer is a weak alkaline salt of pH 6 or more and PH 8 or less.

4. The electronic device of claim 1, wherein the housing has a value of L* 22 or less in a CIE L*a*b* color space.

5. The electronic device of claim 1, wherein the housing has a value of RGB(0.22,0.22,0.22) or less.

6. The electronic device of claim 1, wherein the housing has a gloss of 40GU or more.

7. The electronic device of claim 1, wherein a speed at which the coloring dye particle spreads to the plurality of pores increases as the conductivity enhancer is added.

8. The electronic device of claim 1, wherein a number of H+ ions incorporated in the coloring dye particle decreases as the conductivity enhancer is added.

9. A method (10 of FIG. 5) for manufacturing a glossy housing of an electronic device, the method comprising:
a glossing operation (12 of FIG. 5) for polishing a metal substrate of the housing;
an anodizing operation (14 of FIG. 5) of forming an oxidized film including a plurality of pores; and
a coloring operation (15 of FIG. 5) of coloring by adsorbing an organic dye in the plurality of pores, wherein the coloring operation performs coloring by applying a conductivity enhancer together with the organic dye.

10. The method of claim 9, wherein after the anodizing operation, the housing includes the metal substrate and an anodized layer formed on a surface of the metal substrate.

11. The method of claim 10, wherein the anodized layer includes:
a pore wall including the plurality of pores; and
a coloring dye particle including the organic dye injected to the plurality of pores and the conductivity enhancer.

12. The method of claim 9, wherein the housing has a value of L* 22 or less in a CIE L*a*b* color space.

13. The method of claim 11, wherein a speed at which the coloring dye particle spreads to the plurality of pores increases as the conductivity enhancer is added.

14. The method of claim 11, wherein a number of H+ ions incorporated in the coloring dye particle decreases as the conductivity enhancer is added.

15. The method of claim 11, wherein the metal substrate is at least one metal having a structure capable of adsorbing the coloring dye particle in the plurality of pores by being capable of anodizing.
